Europäisches Patentamt

European Patent Office

Office européen des brevets

(19)

(11) Publication number: **0 004 734**
**B1**

(12) **EUROPEAN PATENT SPECIFICATION**

(45) Date of publication of patent specification: **07.03.84**

(21) Application number: **79300468.0**

(22) Date of filing: **23.03.79**

(51) Int. Cl.³: **G 05 D 11/13,**
**F 02 D 35/00, G 01 R 19/00**

(54) **Comparator.**

(30) Priority: **12.04.78 GB 1441978**

(43) Date of publication of application:
**17.10.79 Bulletin 79/21**

(45) Publication of the grant of the patent:
**07.03.84 Bulletin 84/10**

(84) Designated Contracting States:
**DE FR IT**

(56) References cited:
**DE - A - 2 705 227**
**GB - A - 1 441 660**
**US - A - 3 260 863**
**US - A - 3 569 739**
**US - A - 3 676 702**
**US - A - 3 988 595**
**US - A - 4 028 558**
**US - A - 4 045 686**
**US - A - 4 047 059**

(73) Proprietor: **Hughes Microelectronics Limited**
**Fullerton Road**
**Glenrothes Fife Scotland (GB)**

(72) Inventor: **Fowler, Albert Lewis**
**81 Sauchenbush Road**
**Kirkcaldy Fife, Scotland (GB)**

(74) Representative: **Milhench, Howard Leslie et al,**
**A.A. Thornton & Co. Northumberland House**
**303/306 High Holborn**
**London, WC1V 7LE (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Comparator

This invention relates to a comparator for comparing the magnitude of first and second voltages, comprising inputs for receiving said voltages respectively, a capacitor, control means arranged to apply from the inputs to the capacitor said first voltage during a sequence of first periods and said second voltage during a sequence of second periods each occurring after a respective one of said first periods, an inverter having its input connected to the capacitor, biasing means arranged to apply a bias voltage to the input of the inverter in such a manner as to cause the output from the inverter to assume a particular voltage during said first periods and to assume during said second periods a voltage either greater or less than said particular voltage in dependence upon whether said first voltage is greater or less than said second voltage, and a bistable circuit means arranged to be either set or reset in response to the output of the inverter being either greater or less than said particular voltage during said second periods whereby the set or reset condition of the bistable circuit means is indicative of whether the magnitude of said second voltage is greater or less than the magnitude of said first voltage.

The present invention has particular but not exclusive application to processing electrical signals produced by sensors which sense operating parameters of an internal combustion engine.

Recently, electronic ignition and fuel control systems have been developed for use with automobile internal combustion engines, which permit operation of an engine to be controlled in dependence upon the state of many more operating parameters of the engine than has conventionally been possible. Electrical sensors have been developed to sense the operating parameters of the engine, the sensors providing electrical output voltages which are indicative by their magnitude of the value of the sensed parameters. For example in West German Offenlegungsschrift 2705227 there is described an automobile engine control system utilising a sensor which senses the oxygen content of engine exhaust gases, for use in controlling fuel mixture strength fed to the engine.

In order to process the signals from an electrical sensor into a form suitable for processing in the electronic system, it may be desirable to compare the voltage developed by the sensor with a reference voltage and determine whether the sensor voltage is greater or lesser than the reference voltage.

Comparator circuits suitable for this purpose are known. In US Patent Specification A 3,676,702 to E. P. McGrogan Jr., first and second voltages to be compared ($V_A$, $V_B$) are sequentially switched by means of CMOS transmission gates to one terminal of a capacitor, the other terminal of which is connected to a CMOS inverter. The inverter is provided with a switchable short circuit path between its input and output. The transmission gates and the short circuit path are switched under the control of strobe clock pulses. During a first clock period one of the transmission gates is switched off and the other is switched on so that the voltage $V_B$ is applied to the capacitor. During is first period, the short circuit between the input and output of the inverter is switched on, with the result that the output and input of the inverter are set to a high sensitivity operating point midway between the two output switching states of the inverter. During the next, second clock period, the transmission gates are switched to apply the voltage $V_A$ to the capacitor, so that a voltage $V_A-V_B$ becomes established on the capacitor. Also, the short circuit is removed from the inverter and consequently the inverter output switches to a high or low state depending upon whether the voltage $V_A$ is greater or less than $V_B$. The described process is repeated cyclically under the control of the strobe clock pulses, and the output of the inverter is used to trigger a flip-flop in order to detect $V_A$ changing to become greater or less than $V_B$. Thus, the described comparator provides a digital output signal from the flip-flop indicative of whether $V_A$ is greater or less than $V_B$.

A disadvantage of this prior arrangement is that a short circuit and associated switch is required for the inverter in order to set it to its high sensitivity operating point during the first clock period, which introduces the possibility of switching transients spuriously triggering the inverter during the second clock period. Another problem with the prior circuit is that high sensitivity operating point may tend to drift with time and changes in temperature. McGrogan proposes providing a high impedance feedback path between the input and output of the inverter in order to overcome this problem. However such a feedback path inevitably degrades the gain of the inverter and hence its sensitivity of operation.

The present invention provides a different approach to solving the problem of biasing the inverter to a condition to detect a differential voltage established on the capacitor, which does not require the input to the inverter to be switched, and which automatically compensates for long term drifts in the high sensitivity operating point of the inverter.

The present invention is characterised in that the input of the inverter is biased by means of a further inverter having its input and output connected to one another in a feedback loop, the inputs of the inverters being connected to one another, and the inverters constituting a matched pair sharing the same thermal environment.

In accordance with the present invention, the further inverter, connected in its feedback loop, simulates the thermal drift characteristics of the other inverter and feeds to it on a continuous basis a bias signal which biases the inverter to its high sensitivity operating point. As will be seen from the exemplary comparator circuit of the invention described hereinafter, it is not necessary to provide a switched feedback path from the input to the output of the inverter and hence there is no possibility of switching transients being introduced into the input of the inverter.

Preferably the bistable circuit comprises a D-type flip-flop, and a generating means is provided for applying a control clock waveform to the flip-flop, said clock waveform being arranged to enable the flip-flop to be set or reset only in response to the output of the inverter during said second periods. This preferred arrangement gates out switching transients produced by the inverter changing between its two states.

These and further features and advantages will become apparent from the following description of an embodiment of the invention given by way of illustrative example, with reference to the accompanying drawings, in which:

Figure 1 is a schematic block diagram of a comparator of the present invention used in an oxygen sensing arrangement for sensing oxygen levels in the exhaust gas emission of an internal combustion engine,

Figure 2 illustrates the voltage output characteristic of an oxygen sensor shown in Figure 1,

Figure 3 illustrates in more detail the circuit diagram of the comparator shown in Figure 1, and

Figure 4 illustrates various waveforms developed in use of the circuit shown in Figure 3.

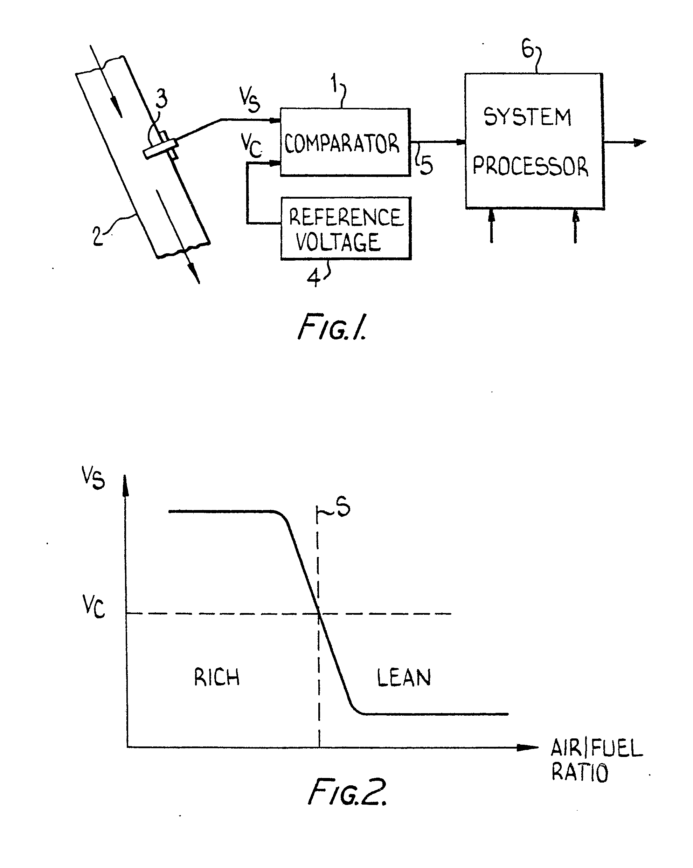

Referring firstly to Figure 1, there is shown a comparator 1 of the present invention used in connection with an internal combustion engine (not shown), to provide a binary signal indicative of whether a rich or lean fuel/air mixture is being fed to the engine. The comparator is connected in an arrangement which measures the oxygen level pertaining in the exhaust gases of the engine, the gases flowing through an exhaust pipe 2. The oxygen level in the exhaust gases is detected by a sensor 3 which comprises a zirconium dioxide element adapted to produce a voltage $V_s$ indicative by its magnitude of the oxygen level in the exhaust gases. One suitable sensor is described in British Patent Specification No. 1,441,660.

Now, it can be shown that the oxygen level obtaining in the exhaust gases of the engine is a function of the ratio of fuel to air in the mixture thereof supplied to the engine, and thus the sensor voltage $V_s$ is a function of the fuel to air ratio of the mixture. A graph of the sensor voltage $V_s$ as a function of the air to fuel ratio of the mixture supplied to the engine, is shown in Figure 2. The appropriate fuel to air ratio for achieving stoichiometric combustion in the engine, is shown by the dotted line S, the regions to the right and left of the line indicating lean and rich mixtures respectively. It will thus be seen that for a rich mixture, the sensor voltage $V_s$ exceeds a voltage $V_c$, whereas for a lean mixture, the sensor voltage $V_s$ is less than the voltage $V_c$. Now, in the apparatus shown in Figure 1, an appropriate reference voltage $V_c$ indicative of stoichiometric combustion conditions, is established by a reference voltage generator 4 and is compared with the voltage $V_s$ produced by the sensor 3, by means of the comparator 1, the comparator providing on line 5 a binary "1" or "0" output signal indicative respectively of a rich or lean fuel/air mixture supplied to the engine. The binary output signal is supplied as one of a plurality of inputs to a system processor 6 which controls the supply of fuel and/or the timing of the eingine's spark ignition in accordance with a plurality of different engine operating parameters.

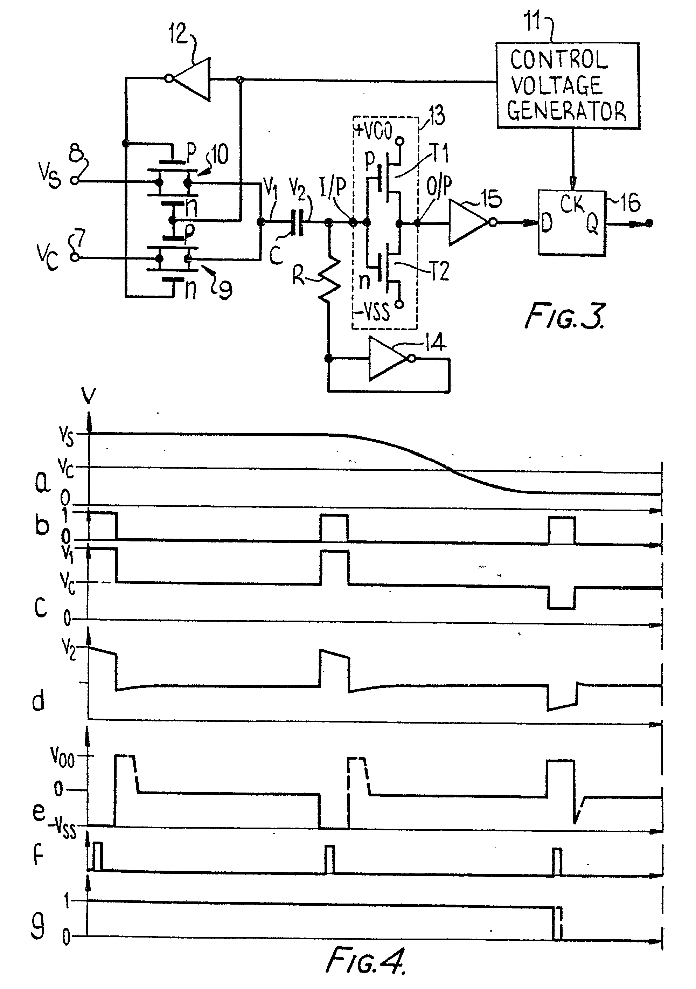

The comparator 1 will now be described in more detail with reference to Figure 3. The voltages $V_s$, $V_c$ produced by the sensor 3 and the voltage generator 4, are applied to input terminals 7 and 8. The terminals 7 and 8 are each series connected to a capacitor C through a switching means in the form of two complementary metal oxide semiconductor (CMOS) transmission gates 9 and 10. The gate electrodes of the complementary transistors of the gates 9, 10 are connected to a control voltage generator 11, to receive therefrom either a control waveform or an inverse thereof, the inverse waveform being produced by a CMOS inverter 12. The arrangement of the transmission gates 9, 10 is such that when the gate 9 is switched on in response to the control waveform to provide a conductive path from the terminal 7 to the capacitor C, the transmission gate 10 is rendered non-conductive in response to the control waveform, and vice versa.

The control waveform produced by the control voltage generator is shown in Figure 4b. The waveform is rectangular and alternates cyclically between 1 and 0 states but is for the most part in its 0 state. Thus, for the periods that the control waveform is in its 1 state, the voltage $V_s$ is connected to the capacitor C, and for the periods that the waveform is in its 0 state, the voltage $V_c$ is connected to the capacitor C. The input waveform to the capacitor is designated $V_1$ in Figure 3 and an example of the waveform $V_1$ is shown in Figure 4c, in respect of the values of $V_s$ and $V_c$ which are shown in Figure 4a. In Figure 4a, the sensor voltage is shown as changing from a value exceeding $V_c$ (indicating a rich mixture) to a value less than $V_c$ (indicating a lean mixture), and accordingly the waveform $V_1$ shown in Figure 4c consists of rectangular pulses during the periods that the control waveform of Figure 4b is in a "1" state, the rectangular pulses having a magnitude greater than $V_c$ when $V_s$ is greater than $V_c$ and the pulses having a magnitude less than $V_c$ when $V_s$ is less than $V_c$.

The input waveform $V_1$ causes an output waveform $V_2$ to be produced by the capacitor C. The output waveform $V_2$ is shown in Figure 4d and is substantially the same as waveform $V_1$ although its rectangularity is degraded somewhat as a result of the capacitor C discharging during the pulses in the waveform. In order to reduce the effects of discharging of the capacitor on the rectangularity of the waveform $V_2$, the periods that the control waveform of Figure 4b is in its 1 state, are made much shorter than the periods that the control waveform is in its 0 state.

The output waveform $V_2$ is applied to a CMOS inverter 13 shown in dotted outline. As is well known, a CMOS inverter comprises p- and n-channel transistors T1 and T2 connected in series between positive and negative voltage rails $+V_{DD}$ and $-V_{SS}$. The gates of the transistors are connected together to define an input I/P and the inverter has an output O/P. When a positive going signal is applied to the input I/P, the n-channel transistor will become switched on to apply a negative voltage from the rail $-V_{SS}$ to the output O/P. Similarly when a negative going signal is applied to the input I/P, the p-channel transistor becomes switched on to apply a positive voltage to the output O/P. Furthermore, when the voltage appleid to the input I/P is a particular value between $V_{DD}$ and $V_{SS}$, the voltage at the output O/P will be 0 volts. The particular value of input voltage which produces a 0 volt output, is itself typically 0 volts but will vary depending upon operating conditions such as temperature etc., to which the inverter is subjected.

Now in the present circuit, a d.c. biasing arrangement comprising a CMOS inverter 14 and a resistor R, is connected to the input I/P of the inverter 13. The biasing arrangement applies to the input I/P a voltage which is so selected that the waveform $V_2$ is at the aforementioned particular voltage appropriate to cause an output voltage of approximately 0 volts at the output O/P of the inverter 13, for the periods that the control waveform of Figure 4b is in its 0 state, with the result that during the periods that the control waveform is in its 1 state, the substantially rectangular pulses in the waveform $V_2$ will cause the inverter 13 to produce rectangular output voltage pulses of either $+V_{DD}$ or $-V_{SS}$ in dependence on whether the substantially rectangular pulses in the waveform $V_2$ are positive or negative going. The waveform produced at the output O/P of the inverter 13 is shown in Figure 4e in respect of the waveform $V_2$ shown in Figure 4d. It will be seen that the rectangularity of the output waveform of Figure 4e will be degraded somewhat as shown in dotted outline, as a result of the non- rectangular nature of the waveform $V_2$, but such degradation of the waveform does not affect operation of the circuit, as will now be explained.

The output of the inverter 13 is connected to a further CMOS inverter 15 which produces an output signal that is the inverse of the waveform shown in Figure 4e. The output signal from the inverter 15 is fed to the D input of a D-type flip-flop 16. The flip-flop is clocked by a control clock waveform generated by the generator 11 as shown in Figure 4f. The control clock waveform comprises clock pulses which respectively occur during the periods that the control waveform of Figure 4b is in its 1 state, and as a result the flip-flop 16 is rendered responsive to the positive or negative polarity of the output of the inverter 15 which occurs during the periods that the control waveform of Figure 4b is in its 1 state. Accordingly, if during such periods the voltage $V_s$ is greater than $V_c$, the voltage produced by inverter 15 will be greater than 0 volts and the flip-flop 16 will be set to a 1 state, but if $V_s$ is less than $V_c$, the flip-flop will be reset to a 0 state. The Q output of the flip-flop 16 is shown in Figure 4g, for the transition of $V_s$ shown in Figure 4a. It will thus be seen that when $V_s$ is greater than $V_c$, the bistable provides a binary "1" output but that at the third clock pulse of Figure 4f, and in response to $V_s$ becoming less than $V_c$, the bistable is reset to produce a binary "0" output, thereby indicating the transition in the value of $V_s$ relative to $V_c$.

The gating effected by the clock pulses of Figure 4f renders the flip-flop 16 responsive to the magnitude of the voltage produced by inverter 15 only during middle portions of the periods that the control waveform of Figure 4b is in its 1 state and accordingly the transients of the waveform of Figure 4e cannot produce spurious setting or resetting of the flip-flop 16.

The d.c. biasing arrangement comprising the inverter 14 and the resistor R, will now be described in more detail. As was mentioned hereinbefore, the particular voltage to be applied to the input I/P of the inverter 13 to achieve a 0 volt output therefrom varies as a function of the inverter's temperature and other operating parameters and accordingly it is desirable that the d.c. bias voltage provided to the input of the inverter 13 adjusts itself in magnitude automatically to accommodate any changes in temperature and other operating parameters. To this end, the invertes 13 and 14 are constructed as a matched pair in the same thermal environment, receiving the same rail voltages $V_{DD}$, $V_{SS}$. The inverter 14 has its output connected to its input in a feedback loop and as a result, the input and output assume the same voltage level $V_o$ which is disposed between the rail voltages $V_{DD}$, $V_{SS}$. This voltage level $V_o$ is a function of the temperature and other operating parameters of the inverter 14, and varies as a function of these operating parameters in the same way as the aforementioned voltage which needs to be applied to the input I/P of the inverter 13 to achieve a 0 volt output voltage therefrom. An appropriate proportion of the voltage $V_o$ is dropped across the resistor R (NB. in practice this voltage drop is zero) such as to appropriately bias the input I/P of the inverter 13 so that the voltage level of the waveform $V_2$, during the periods that the control waveform of Figure 4*b* is in its 0 state, is equal to the aforementioned voltage appropriate to achieve a zero voltage output from the inverter 13. Since the voltage $V_o$ varies as a function of the operating parameters of the inverter 13, the bias voltage produced by the inverter 14 and the resistor R will adjust its magnitude automatically in accordance with temperature changes and changes of other operating parameters of the inverter 13.

Many modifications and variations of the above described comparator arrangement are possible and for example the comparator could be used with a sensor other than an oxygen sensor. Also, the reference voltage can be made to vary in magnitude as a function of the combustion conditions of the engine.

## Claims

1. A comparator for comparing the magnitude of first and second voltages (Vc, Vs), comprising inputs (7, 8) for receiving said voltages respectively, a capacitor (C), control means (9, 10, 11, 12) arranged to apply from the inputs to the capacitor said first voltage (Vc) during a sequence of first periods and said second voltage (Vs) during a sequence of second periods each occurring after a respective one of said first periods, an inverter (13) having its input connected to the capacitor, biasing means arranged to apply a bias voltage to the input of the inverter in such a manner as to cause the output from the inverter to assume a particular voltage during said first periods and to assume during said second periods a voltage either greater or less than said particular voltage in dependence upon whether said first voltage is greater or less than said second voltage, and a bistable circuit means (16) arranged to be either set or reset in response to the output of the inverter being either greater or less than said particular voltage during said second periods whereby the set or reset condition of the bistable circuit means is indicative of whether the magnitude of said second voltage (Vs) is greater or less than the magnitude of said first voltage (Vc), characterised in that said biasing means comprises a further inverter (14) having its input and output connected to one another in a feedback loop, and ressitive means (R) providing an interconnection between the inputs of the inverters, the inverters constituting a matched pair sharing the same thermal environment.

2. A comparator in accordance with claim 1 wherein said bistable circuit means (16) comprises a D-type flip-flop, and including generating means (11) for applying a control clock waveform to the flip-flop, said clock waveform being arranged to enable the flip-flop to be set or reset only in response to the output of said inverter (13) during said second periods.

3. A comparator in accordance with claim 2 wherein for each said second period said control clock period is arranged to effect said enabling of the flip-flop for a duration less than the duration of the said second period.

4. A comparator in accordance with any preceding claim wherein the control means includes two switching devices (9, 10) each of which is connected in series with the capacitor (C) and a respective one of said inputs (7, 8), and generating means (11) for applying a control waveform to the switching devices in such a manner as to switch cyclically said devices between relatively high and low conductivity states wherein when one said devices is in its high conductivity state the other of said devices is in its low conductivity state, whereby to define said first and second periods.

5. A comparator in accordance with claim 4 wherein said switching devices (9, 10) comprise CMOS transmission gates.

6. A comparator in accordance with any one of claims 2 to 5 wherein said first periods are of a substantially greater duration than said second periods.

7. A comparator in accordance with any preceding claim wherein said inverters (13, 14) comprise CMOS inverters.

8. A comparator in accordance with any preceding claim and having connected to one of said inputs thereof (8) an oxygen sensor (3) for generating an electrical voltage indicative by its magnitude of the level of oxygen sensed thereby, and the comparator having connected to the other input thereof (7) a reference voltage generator (4) for generating a substantially constant voltage.

9. A comparator in accordance with any preceding claim including a resistor (R) interconnecting the inputs of the inverters.

## Patentansprüche

1. Komparator zum Größenvergleich einer ersten mit einer zweiten Spannung (Vc, Vs) mit Eingängen (7, 8) zum Empfang der jeweiligen Spannungen, mit einem Kodensator (C), mit Steuermitteln (9, 10, 11, 12), die die erste Spannung (Vc) während einer Folge erster Zeittakte und die zweite Spannung (Vs) während einer Folge zweiter, jeweils nach einem Zugehörigen ersten Zeittakt auftretender Zeittakte von den Eingängen an den Kondensator legen, mit einem Inverter (13), dessen Eingang mit dem Kondensator verbunden ist, mit Vorspannungsmitteln, die eine Vorspannung an den Eingang des Inverters legen, derart, daß der Ausgang des Inverters eine bestimite Spannung während der ersten Zeittakte und eine dem-

9 0 004 734 10

gegenüber größere oder kleinere Spannung während der zweiten Zeittakte annimmt, abhängig davon, ob die erste Spannung größer oder kleiner als die zweite Spannung ist, mit bistabilen Schaltmitteln (16), die abhängig vom Ausgangssignal des Inverters, das seinerseits größer oder kleiner als die bestimmte Spannung während der zweiten Zeittakte ist, gesetzt oder rückgesetzt werden, wodurch der Zustand "gesetzt" bzw. "rückgesetzt" der bistabilen Schaltmittel ein Maß dafür ist, ob der Betrag der ersten Spannung (Vs) größer oder kleiner als der Betrag der zweiten Spannung (Vc) ist, dadurch gekennzeichnet, daß die Vorspannungsmittel einen weiteren Inverter (14), dessen Eingang und Ausgang in einer Rückkopplungsschleife miteinander verbunden sind, sowie Widerstandsmittel (R) aufweisen, die eine Verbindung zwischen den Eingängen der Inverter herstellen, wobei die Inverter ein aufeinander abgestimmtes Paar sind, das sich in derselben thermischen Umgebung befindet.

2. Komparator nach Anspruch 1, dadurch gekennzeichnet, daß die bistabilen Schaltmittel (16) ein D-Flipflop umfassen sowie Generatormittel (11), die dem Flipflop einen Steuertakt zuführen, der so gestaltet ist, daß das Flipflop nur in Abhängigkeit vom Ausgangssignal des Inverters (13) während der zweiten Zeittakte gesetzt oder rückgesetzt werden kann.

3. Komparator nach Anspruch 2, dadurch gekennzeichnet, daß während jeder Periodendauer des zweiten Zeittaktes die Periodendauer des Steuertaktes so ausgelegt ist, daß das Flipflop während einer Zeitdauer, die kürzer als die Periodendauer der zweiten Zeittakte ist, ansteuerbar ist.

4. Komparator nach einem der vorhergehenden Ansprüche, dadurch gekennzeichnet, daß die Steuermittel zwei Schalter (9, 10) umfassen, die jeweils in Reihe mit dem Kondensator (C) und jeweils einem der Eingänge (7, 8) liegen, daß die Kontrollmittel ferner Generatormittel (11) umfassen, die ein Regelsignal an die Schalter legen, derart, daß die Schalter zyklisch zwischen einem Zustand relativ hoher bzw. relativ niedriger Leitfähigkeit hin- und hergeschaltet werden, wobei dann, wenn einer der Schalter im Zustand hoher Leitfähigkeit ist, der andere Schalter im Zustand niedriger Leitfähigkeit ist, wodurch der erste und der zweite Zeittakt definiert sind.

5. Komparator nach Anspruch 4, dadurch gekennzeichnet, daß die Schalter (9, 10) CMOS-Transmissionsgatter umfassen.

6. Komparator nach einem der Ansprüche 2 bis 5, dadurch gekennzeichnet, daß die ersten Zeittakte eine wesentlich längere Zeitdauer aufweisen als die zweiten Zeittakte.

7. Komparator nach einem der vorhergehenden Ansprüche, dadurch gekennzeichnet, daß die Inverter (13, 14) CMOS-Inverter um-fassen.

8. Komparator nach einem der vorhergehenden Ansprüche, dadurch gekennzeichnet, daß an einem seiner Eingänge (8) ein Sauerstoffsensor angeschlossen ist, der eine elektrische Spannung in Abhängigkeit des von ihm erfaßten Sauerstoffgehaltes erzeugt, wobei an den anderen Eingang (7) des Komparators ein Referenzspannungs-Erzeuger (4) angeschlossen ist, der eine im wesentlichen konstante Spannung erzeugt.

9. Komparator nach einem der vorhergehenden Ansprüche, dadurch gekennzeichnet, daß ein Widerstand die Eingänge des Inverters miteinander verbindet.

**Revendications**

1. Comparateur destiné à comparer les amplitudes de première et seconde tensions (Vc, Vs), comprenant des entrées (7, 8) destinées à recevoir lesdites tensions, respectivement, un condensateur (C), des moyens de commande (9, 10, 11, 12) agencés pour appliquer, à partir des entrées, au condensateur, ladite première tension (Vc) pendant une séquence de premières périodes et ladite seconde tension (Vs) pendant une séquence de secondes périodes apparaissant chacune après l'une, correspondante, desdites premières périodes, un inverseur (13) ayant son entrée connectée au condensateur, des moyens de polarisation agencés pour appliquer une tension de polarisation à l'entrée de l'inverseur de manière que la sortie de l'inverseur prenne une tension particulière pendant lesdites premières périodes et prenne, pendant lesdites secondes périodes, une tension supérieure ou inférieure à ladite tension particulière, suivant que ladite première tension est supérieure ou inférieure à ladite seconde tension, et des moyens à circuit bistable (16), agencés pour être positionnés ou repositionnés suivant que la sortie de l'inverseur est supérieure ou inférieure à ladite tension particulière pendant lesdites secondes périodes, l'état de positionnement ou de repositionnement des moyens à circuit bistable étant représentatif du fait que l'amplitude de ladite seconde tension (Vs) est supérieure ou inférieure à l'amplitude de ladite première tension (Vc), caractérisé en ce que lesdits moyens de polarisation comprennent un autre inverseur (14) ayant ses entrées et sorties connectées l'une à l'autre en une boucle de réaction, et des moyens résistifs (R) établissant une interconnexion entre les entrées des inverseurs, les inverseurs constituant une paire équilibrée partageant le même milieu thermique.

2. Comparateur selon la revendication 1, dans lequel lesdits moyens (16) à circuit bistable comprennent une bascule du type D, et comprenant des moyens générateurs (11) destinés à appliquer un signal d'horloge de commande à la bascule, ledit signal d'horloge étant conçu pour autoriser la bascule à être positionnée ou repositionnée uniquement en réponse à la sortie dudit inverseur (13) pendant lesdites secondes périodes.

3. Comparateur selon la revendication 2, dans lequel, pendant chacune desdites secondes périodes, ladite période d'horloge de commande est conçue pour effectuer ladite autorisation de la bascule pendant une durée inférieure à la durée de ladite seconde période.

4. Comparateur selon l'une quelconque des revendications précédentes, dans lequel les moyens de commande comprennent deux dispositifs de commutation (9, 10) connectés chacun en série avec le condensateur (C) et l'une, correspondante, desdites entrées (7, 8), et des moyens générateurs (11) destinés à appliquer un signal de commande aux dispositifs de commutation de manière à commuter cycliquement lesdits dispositifs entre des états de conductivité relativement haute et basse, afin que, lorsque l'un desdits dispositifs est dans son état de haute conductivité, l'autre desdits dispositifs soit dans son état de basse conductivité, de façon à définir ainsi lesdites premières et secondes périodes.

5. Comparateur selon la revendication 4, dans lequel lesdits dispositifs de commutation (9, 10) comprennent des portes de transmission CMOS.

6. Comparateur selon l'une quelconque des revendications 2 à 5, dans lequel lesdites première périodes sont d'une durée sensiblement supérieure auxdites secondes périodes.

7. Comparateur selon l'une quelconque des revendications précédentes, dans lequel lesdits inverseurs (13, 14) comprennent des inverseurs CMOS.

8. Comparateur selon l'une quelconque des revendications précédentes et à l'une desdites entrées (8) duquel est connecté un captuer d'oxygène (3) destiné à produire une tension électrique représentative, par son amplitude, du niveau d'oxygène qu'il détecte, un générateur (4) de tension de référence, destiné à générer une tension sensiblement constante, étant connecté à l'autre entrée (7) du comparateur.

9. Comparateur selon l'une quelconque des revendications précédentes, comprenant une résistance (R) interconnectant les entrées des inverseurs.

FIG.1.

FIG.2.

FIG.3.

FIG.4.